# EUROPÄISCHE PATENTSCHRIFT

(11) **EP 0 591 836 B1**
(45) Veröffentlichungstag und Bekanntmachung des Hinweises auf die Patenterteilung: **23.04.1997**
(21) Anmeldenummer: 93115762.2
(22) Anmeldetag: 30.09.1993
(51) Int. Cl.: B23Q 7/14

(54) **Einrichtung mit einem Transportsystem**
Installation with a transporting system
Installation avec un système de transport

(30) Priorität: 05.10.1992 DE 4233438
(43) Veröffentlichungstag der Anmeldung: 13.04.1994
(73) Patentinhaber: Stribel GmbH, D-72636 Frickenhausen (DE)
(72) Erfinder: Stribel, Hans Peter, D-72622 Nürtingen (DE)

(56) Entgegenhaltungen:
- EP-A- 0 456 218
- EP-A- 0 491 448
- DE-A- 4 139 189
- US-A- 4 397 384
- US-A- 4 930 258
- 16th Annual Conference of IEEE Industrial Electronics Society, November 27-30, 1990 Asilomar Conference Center, Pacific Grove, California
- WERKSTATTSTECHNIK, ZEITSCHRIFT FUR INDUSTRIELLE FERTIGUNG, Bd.78, Nr.12, Dezember 1988, BERLIN DE Seiten 679 - 682 G. BOERNECKE 'Fliessfertigungskonzepte fuer variantenreiche Produkte'

## Beschreibung

Die Erfindung betrifft eine Einrichtung mit den Merkmalen des Oberbegriffs des Anspruchs 1.

Aus der EP-A-491448 ist eine Einrichtung dieser Art bekannt, die Teilkomponenten taktzeitabhängig zu Handhabungseinrichtungen und die fertigen Funktionseinheiten zu einer Entnahmeeinrichtung befördert. Die Einrichtung enthält eine erste Fördereinrichtung zum Transport der auf Ablageeinrichtungen deponierten Teilkomponenten im Teilbereitstellungsbereich. Außerdem enthält die Einrichtung eine zweite Fördereinrichtung zum Transport der auf Werkstückträgern montierbaren Teilkomponenten im Endmontagebereich. Die erste und die zweite Fördereinrichtung sind im Endmontagebereich zueinander parallel angeordnet und können mit unterschiedlicher Fördergeschwindigkeit angetrieben werden.

IECON'90, 16th Annual Conference of IEEE Industrial Electronics Society, Volume I, pages 576-580 "Automated Visual Inspection of Surface Mount PCBs", E Teoh, offenbart eine Bildverarbeitungsstation zur Prüfung von Werkstücken. Die Istwerte der Werkstücke werden von einer Kamera aufgenommen und einem Rechner zugeführt, der die Istwerte mit den gespeicherten Sollwerten der Werkstücke vergleicht und nicht zulässige Werteabweichungen signalisiert.

Die Aufgabe der Erfindung besteht darin, eine Einrichtung mit den Merkmalen des Oberbegriffs des Anspruchs 1 dahingehend weiterzubilden, daß mit einfachen Mitteln eine weitgehend vollautomatische Bearbeitung und Montage verschiedener Werkstückteile mit integrierter Qualitätssteuerung erzielt wird.

Diese Aufgabe wird erfindungsgemäß durch die kennzeichnenden Merkmale des Anspruchs 1 gelöst.

Zweckmäßige Ausgestaltungen und Weiterbildungen der Erfindung sind durch die Merkmale der Unteransprüche gekennzeichnet.

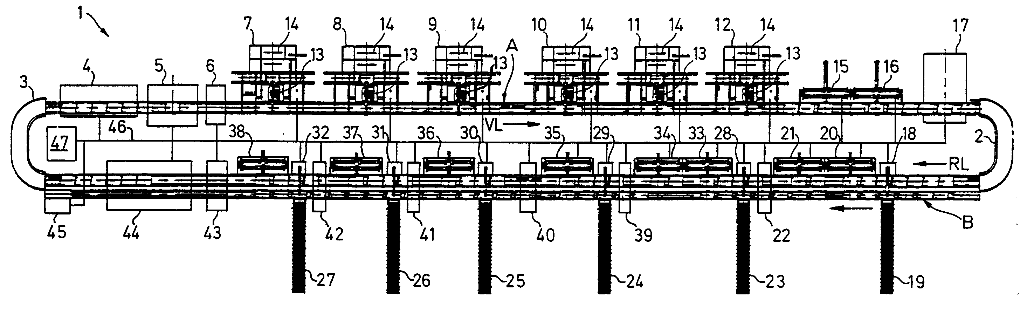

Weitere Vorteile und wesentliche Einzelheiten der Erfindung sind der nachfolgenden Beschreibung und der Zeichnung zu entnehmen, die in schematischer Darstellung eine bevorzugte Ausführungsform als Beispiel zeigt.

Die in der Zeichnung dargestellte erfindungsgemäße Einrichtung weist ein Transportsystem 1 auf, das zweckmäßig aus aneinandergereihten eigenständigen Arbeitsplatzeinheiten modular aufgebaut sein kann. Das Transportsystem 1 kann vorteilhaft ein erstes Umlaufsystem A und ein zweites Umlaufsystem B aufweisen. Das Umlaufsystem A kann eine Vorlaufstrecke VL und eine Rücklaufstrecke RL besitzen, deren Förderrichtung durch in der Zeichnung dargestellte Pfeile angezeigt ist.

Die Vorlaufstrecke VL und die Rücklaufstrecke RL können vorteilhaft parallel zueinander verlaufen, wobei zwischen dem Vorlauf und dem Rücklauf ein Abstand bestehen kann. Das Ende der Vorlaufstrecke VL und der Anfang der Rücklaufstrecke RL können über einen Umlenkteil 2 verbunden sein. Ebenso können das Ende der Rücklaufstrecke RL und der Anfang der Vorlaufstrecke VL über einen weiteren Umlenkteil 3 verbunden sein, so daß eine geschlossene Umlaufstrecke für die auf dem ersten Umlaufsystem A zu transportierenden Werkstückträger gegeben ist. Die Umlenkteile 2,3 können als Rollenkurve ausgebildet sein, die bevorzugt über einen Motor antreibbar ist.

Das zweite Umlaufsystem B kann bevorzugt parallel zum ersten Umlaufsystem A verlaufen und zweckmäßig an dessen einer Außenseite direkt neben der Rücklaufstrecke RL angeordnet sein. Die Förderrichtung des Umlaufsystems B und die Förderrichtung der Rücklaufstrecke RL sind gleich, wie den Richtungspfeilen zu entnehmen ist.

In der Zeichnung ist dargestellt, daß die erfindungsgemäße Einrichtung verschiedene Bearbeitungsstationen aufweisen kann. Der Produktionsprozeß beginnt am Anfang der Vorlaufstrecke VL an einer Beschickungsstation 4, der eine Bildverarbeitungsstation 5 und eine Nachbearbeitungsstation 6 nachgeordnet sind. Hinter der Nachbearbeitungsstation 6 können mehrere, vorzugsweise sechs Pressen 7 bis 12 vorgesehen sein. Diese Werkstückbearbeitungspressen können mit unterschiedlichen Werkzeugen ausgestattet sein und jeweils einen Nebenschlußförderer 13 sowie ein vertikal und horizontal verfahrbares Handlingsystem 14 aufweisen. Das Handlingsystem 14 kann einen Werkstückgreifer besitzen.

Darüber hinaus ist zu erkennen, daß hinter der letzten Presse 12 zwei weitere Bearbeitungsstationen, nämlich zwei sogenannte Umsetzstationen 15,16 angeordnet sind, hinter denen am Ende der Vorlaufstrecke VL eine Schweißstation 17 vorgesehen sein kann. In den Umsetzstationen 15,16 können z.B. zusätzliche Teile von außen zugeführt werden, die an der Schweißstation 17 mit den zuvor bearbeiteten Produktionsteilen verbunden werden können. Am Beginn der Rücklaufstrecke RL befindet sich ein mehrachsig bewegbarer Manipulator 18. Gegenüber diesem befindet sich auf der anderen Seite des Umlaufsystems B eine Zuführeinrichtung 19, mittels der dem Manipulator 18 Ergänzungswerkstücke zugeführt werden können. Hinter dem Manipulator 18 können in Förderrichtung des ersten Umlaufsystems A zwei Montageroboter 20,21 angeordnet sein. Hinter dem Montageroboter 21 kann sich zweckmäßig eine Bildverarbeitungsstation 22 befinden. Im Anschluß an die Bildverarbeitungsstation 22 können in Förderrichtung des zweiten Umlaufsystems B in Abständen weitere Zuführeinrichtungen 23 bis 27 vorgesehen sein und in Förderrichtung der Rücklaufstrecke RL können ebenfalls weitere Manipulatoren 28 bis 32, Montageroboter 32 bis 38 und Bildverarbeitungsstationen 39 bis 43 angeordnet sein. Am Ende des Montagevorgangs des ersten Umlaufsystems A beziehungsweise der Rücklaufstrecke RL befindet sich eine Endbearbeitungsstation 44 für die Werkstücke und am Ende des zweiten Umlaufsystems B ist eine Liftstation 45 für die Werkstückträger vorgesehen.

Die erfindungsgemäße Einrichtung kann vorzugsweise für die Montage von sogenannten Zentralelektriken vorgesehen sein, die im wesentlichen aus in mehreren Schichten übereinander angeordneten metallischen Leiterstegen sowie die Leiterstegebenen trennenden Isolierplatten und Gehäuseabschlußplatten bestehen. Die Leiterstege werden als vorgestanzte und vorgebogene Metallgitter angeliefert, die auf der Vorlaufstrecke VL des ersten Umlaufsystems A zur Bildung der verschiedenen Leiterstege entsprechend ausgestanzt werden, wobei vorzugsweise sechs verschiedene Metallgitter vorgelegt werden. Auf der Rücklaufstrecke RL werden die Stege mit den Kunststoff-Isolierplatten zur Zentralelektrik montiert.

Zunächst werden an der Beschickungsstation 4 die sechs verschiedenen Metallgitter einzeln auf sechs zugehörige Werkstückträger gelegt. Die Werkstückträger sind so gestaltet, daß Metallgitter mit nach unten abgewinkelten Kontaktzungen nicht aufgelegt werden können, da es sonst in den folgenden automatischen Stationen zu Störungen kommen könnte. Fehlerhafte Metallgitter werden entweder nachgebessert oder aussortiert.

Danach gelangen die so bestückten Werkstückträger zu der Bildverarbeitungsstation 5, die vorzugsweise mit sechs Kameras bestückt sein kann. Die von den Kameras aufgenommenen Bilder werden in Signale umgesetzt, die einem Rechner zugeführt werden, der die Istwerte mit den gespeicherten Sollwerten der Werkstücke vergleicht. Dabei wird geprüft, ob die einzelnen Metallgitter sich jeweils auf dem richtigen zugehörigen Werkstückträger befinden und ob die nach oben abgewinkelten Kontaktzungen vollzählig sind und sich in der richtigen Position befinden. Die Bildverarbeitungsstation 5 kann alle sechs verschiedenen Werkstückträger beziehungsweise Metallgitter in beliebiger Reihenfolge prüfen, wobei jeder Kamera ein bestimmtes Metallgitter zugeordnet sein kann. Wenn die Bildverarbeitungsstation 5 nicht zulässige Werteabweichungen feststellt, können letztere akustisch und/oder optisch signalisiert werden, so daß die Fehler anschließend behoben werden können. Außerdem können die Feststellungen in der Bildverarbeitungsstation 5 gespeichert und ausgewertet werden, so daß gleichzeitig eine statistische Prozeßkontrolle möglich ist.

Nach dem Verlassen der Bildverarbeitungsstation 5 passieren die Werkstückträger die Nachbearbeitungsstation 6, in der mögliche Fehler behoben oder mangelhafte Gitter ausgesondert werden können. Dazu wird der Werkstückträger mit dem bemängelten Metallgitter in der Station zurückgehalten. Durch eine optische und/oder akustische Meldung wird auf das fehlerhafte Merkmal hingewiesen und veranlaßt, entweder nachzuarbeiten oder zu selektieren. Ein eventuell zurückgehaltener Werkstückträger wird nach Quittierung der Fehlerbehebung von der Steuerung freigegeben. Die Steuerung kann über einen Computer erfolgen, der mit den verschiedenen Bearbeitungsstationen des ersten Umlaufsystems A und des zweiten Umlaufsystems B verknüpft ist. Der Computer steuert die einzelnen Stationen und koordiniert den Datenaustausch zwischen den Stationen.

In den nachfolgenden Pressen 7 bis 12 können Leiterstege aus den Metallstreifen herausgetrennt werden. Für jedes der einzelnen Metallgitter ist eine der Pressen 7 bis 12 mit entsprechendem Schnittwerkzeug zuständig. Das erste Metallgitter gelangt beispielsweise in die Presse 7, das zweite Metallgitter in die Presse 8 und so weiter. Für einen automatischen Transfer des Metallgitters ins Schnittwerkzeug besitzt jede Presse 7 bis 12 einen Nebenschlußförderer 13 und ein Handlingsystem 14, das vertikal und horizontal bewegbar ist. Ein am Handlingsystem 14 befindlicher Greifer kann die noch mit dem Metallgitter verbundenen Leiterstege aus dem Werkstückträger entnehmen und in die Matrize einlegen. Nach dem Abtrennen der Leiterstege können letztere mittels des Greifers gleichzeitig aus der Matrize in den Werkstückträger zurückgesetzt werden. Die Schnittwerkzeug-Matrize kann auf einem Schlitten aus der Presse herausgefahren werden. Nach dem Passieren der Pressen 7 bis 12 sind in den Werkstückträgern ausschließlich ausgestanzte Leiterstege gelagert.

Hinter der letzten Presse 12 können die einzelnen Leiterstege in den beiden Umsetzstationen 15,16 zusammengesetzt oder durch zusätlich bearbeitete Leitereinzelteile komplettiert werden. Die verschiedenen Einzelteile können in der dahinter befindlichen Schweißstation 17 wahlweise miteinander verbunden werden.

Nach dem Verlassen der Schweißstation 17 werden die Werkstückträger mit den Leiterstegen über den vorzugsweise als Rollenkurve ausgebildeten Umlenkteil 3 zum Anfang der Rücklaufstrecke RL gefördert. Nun werden die Werkstückträger des zweiten Umlaufsystems B, das vorzugsweise genauso lang ist wie die Rücklaufstrecke RL, mit einer ersten Isolierplatte aus der Zuführeinrichtung 19 bestückt. Dies geschieht mittels des horizontal und vertikal bewegbaren Manipulators 18, der eine oder mehrere Kompaktzangen aufweisen kann, die die Isolierplatte von der Zuführeinrichtung 19 abhebt und auf den Werkstückträger legt. Für die genaue Positionierung der Isolierplatte können zum Beispiel pneumatisch bewegbare Schieber sowie entsprechende Anschläge vorgesehen sein. Eine Anwesenheitskontrolle der Ergänzungswerkstücke beziehungsweise Isolierplatten sowie das Anhalten der Zuführeinrichtung 19 kann über Lichtschranken erfolgen.

Der Werkstückträger des ersten Umlaufsystems A mit den Leiterstegen und der andere Werkstückträger des zweiten Umlaufsystems B mit der Isolierplatte werden nun parallel nebeneinander zu den Montagerobotern 20,21 gefördert. Hier wird die erste Isolierplatte bestückt. Dazu werden aus den Werkstückträgern 1 bis 6 des ersten Umlaufsystems A die für die erste Isolierplatte benötigten Leiterstege von den Montagerobotern 20,21 entnommen und in die auf dem Werkstückträger des parallelen zweiten Umlaufsystems B befindliche erste Isolierplatte eingesetzt. Die Montageroboter 20,21 sind in verschiedenen Richtungen bewegbar und mit teilespezifischen Sondergreifwerkzeugen sowie einem Greiferwechselsystem ausgestattet. Die Greifer können in programmvorgegebener Reihenfolge einem Greifermagazin entnommen und nach erfolgter Teilemontage wieder dort abgelegt werden. Um eine einwandfreie Funktion zu gewährleisten, können die vorzugsweise mit Druckluft betriebenen Montageroboter 20,21 Wartungseinheiten und Feinstfilter sowie einen zum Beispiel etwa zehn Liter großen Druckspeicher aufweisen, um eine druckstabile, ölfreie und saubere Druckluft zu gewährleisten. Nachdem alle notwendigen Leiterstege in die erste Isolierplatte eingesetzt wurden, werden die Vollzähligkeit und die richtige Position der eingesetzten Teile in der Bildverarbeitungsstation 22 über eine Kamera und einen zugehörigen Rechner kontrolliert, wobei die Istwerte mit den Sollwerten verglichen werden und bei nicht zulässigen Abweichungen eine entsprechende Signalgabe erfolgt. Die ermittelten Daten können im Rechner gespeichert und mittels einer statistischen Prozeßkontrolle ausgewertet werden.

Die restlichen fünf Isolierplatten werden über die in Förderrichtung auf Abstand angeordneten Zuführeinrichtungen 23 bis 27 vorgelegt und von den Manipulatoren 28 bis 32 auf die Werkstückträger des zweiten Umlaufsystems B gesetzt. Wie zuvor beschrieben, werden dann über die Montageroboter 33 bis 38 die jeweils notwendigen Leiterstege in die entsprechenden restlichen Isolierplatten eingesetzt. Das Montageergebnis einer jeden Isolierplattenbestückung kann durch die den jeweiligen Arbeitsvorgängen nachgeordneten Bildverarbeitungsstationen 39 bis 43 kontrolliert und überwacht werden. Die Bildverarbeitungsstationen 5,22 und 39 bis 43 können zweckmäßig so ausgelegt sein, daß sie auch feststellen können, ob die Metallgitter beziehungsweise Leiterstege aus dem jeweils richtigen Material sind, also zum Beispiel aus Eisen, Messing oder Kupfer bestehen.

Nach dem Verlassen der letzten Bildverarbeitungsstation 43 gelangen die Werkstückträger des zweiten Umlaufsystems B mit den sechs mit Leiterstegen bestückten und übereinandergeschichteten Isolierplatten zu der Endbearbeitungsstation 44, wo eine obere, mit Führungsschlitzen für die Einzelteile versehene Kulisse aufgesteckt wird und anschließend ein haubenförmiger Deckel aufgesetzt wird, der die bestückten Isolierplatten oben und seitlich übergreift und mit einer Bodenplatte verbunden wird, so daß eine kompakte Zentralelektrik-Baueinheit gegeben ist.

Mittels der am Ende des zweiten Umlaufsystems B vorgesehenen Liftstation 45 können die bestückten Baueinheiten abgesenkt und gestapelt werden. Es besteht auch die Möglichkeit, die leeren Werkstückträger des Umlaufsystems B über die Liftstation 45 auf ein Rücktransportband des Umlaufsystems B abzusenken.

Die Steuerungen der einzelnen Arbeitsstationen der erfindungsgemäßen Einrichtung können vorzugsweise über ein Zwei-Draht-Bussystem 46 miteinander verknüpft sein, wobei zum Beispiel ein Personal-Computer 47 als sogenannter Master im Netz den Datenaustausch mit den Slave-Teilnehmern koordiniert. An dieses Netzwerk können eine Vielzahl von Teilnehmern angeschlossen sein. Der PC 47 als Leitrechner kann außerdem die von den Bildverarbeitungsstationen 5,22,39 bis 43 erhaltenen Prüfdaten an die jeweilige Steuerung der folgenden Montage- beziehungsweise Bearbeitungsstationen schicken. Außerdem können die im PC 47 registrierten Daten der Bildverarbeitungsstationen 5,22,39 bis 43 und der Steuerungen abgespeichert, verarbeitet und über Drucker ausgegeben werden. Darüber hinaus kann im PC 47 ein Steuerprogramm installiert sein, um die Betriebsart von zentraler Stelle aus vorzuwählen beziehungsweise umzuschalten. Dabei können sowohl einzelne Steuerungen (zum Beispiel Einrichtebetrieb, Testbetrieb) als auch alle Steuerungen gemeinsam (zum Beispiel Stückzahlvorgaben, Variantenfertigung) adressiert werden.

Um einen planmäßigen Werkstückträgerumlauf der sechs verschiedenen Werkstückträger im ersten Umlaufsystem A zu gewährleisten, kann letzteres mit einem elektronischen Identifikations- und Kodiersystem ausgerüstet sein. Die Schreib- und Leseköpfe dieses Identifikations- und Kodiersystems können an die einzelnen Steuerungen über eine Standardschnittstelle angeschlossen sein. Das Ausschleusen der Werkstücke beziehungsweise Werkstückträger zu den Bearbeitungsstationen, insbesondere den Pressen 7 bis 12, sowie das Wiedereinschleusen ins Umlaufsystem A in der richtigen Reihenfolge und das Erkennen des benötigten Werkstückträgers in der jeweiligen Montagestation kann damit erreicht werden. Zudem kann der Fertigungsfortschritt der Baugruppen auf den Datenspeicher geschrieben werden.

## Patentansprüche

1. Einrichtung mit einem Transportsystem zur Bearbeitung von auf Werkstückträgern positionierbaren Werkstücken, wobei für die Werkstückträger ein erstes Umlaufsystem (A) und ein zweites Umlaufsystem (B) vorgesehen ist und mindestens eines der Umlaufsysteme (A, B) eine Vorlaufstrecke (VL) und eine Rücklaufstrecke (RL) aufweist, **dadurch gekennzeichnet,** daß hinter einer Nachbearbeitungsstation (6) des ersten Umlaufsystems (A) eine oder mehrere Pressen (7, 12) vorgesehen sind, denen je eines der verschieden gestalteten Werkstücke zuführbar ist, und hinter der Pressenstation (7 bis 12) mindestens eine die Werkstückeinzelteile zusammenstellende und/oder ergänzende Umsetzstation (15, 16) vorgesehen ist, daß dem zweiten Umlaufsystem (B) mindestens eine Ergänzungswerkstücke antragende Zuführeinrichtung (19, 23 bis 27) und ein die Ergänzungswerkstücke auf zugehörige Werkstückträger des zweiten Umlaufsystems (B) auflegender Manipulator (18, 28 bis 32) zugehörig ist, daß das zweite Umlaufsystem (B) die Ergänzungswerkstücke auf deren Werkstückträgern neben den Werkstückeinzelteilen der Werkstückträger des ersten Umlaufsystems (A) transportiert, daß dem Manipulator (18, 28 bis 32) des zweiten Umlaufsystems (B) mindestens ein die Werkstückeinzelteile von den Werkstückträgern des ersten Umlaufsystems (A) auf die Ergänzungswerkstücke des zweiten Umlaufsystems (B) aufsetzender Montageroboter (21, 33 bis 38) nach geordnet ist, daß mindestens eine die Werkstücke prüfende Bildverarbeitungsstation (5, 22, 39 bis 43) vorgesehen ist, die mindestens eine Kamera aufweist, die die Istwerte der Werkstücke aufnimmt, welche einem Rechner zugeführt werden, der die Istwerte mit den gespeicherten Sollwerten der Werkstücke vergleicht und nicht zulässige Werteabweichungen signalisiert, und daß die Bildverarbeitungsstation (5, 22, 39 bis 43) und weitere Bearbeitungsstationen (4 und 6 bis 45) des ersten Umlaufsystems (A) und des zweiten Umlaufsystems (B) über einen Computer (47) miteinander verknüpft sind, der die einzelnen Stationen steuert und den Datenaustausch zwischen den Stationen koordiniert.

2. Einrichtung nach vorstehendem Anspruch, dadurch gekennzeichnet, daß die Vorlaufstrecke (VL) des ersten Umlaufsystems (A) mit der Rücklaufstrecke (RL) über mindestens einen die Förderrichtung ändernden Umlenkteil (2, 3) verbunden ist.

3. Einrichtung nach einem oder mehreren der vorstehenden Ansprüche, dadurch gekennzeichnet, daß die Vorlaufstrecke (VL) und die Rücklaufstrecke (RL) auf Abstand parallel zueinander angeordnet sind.

4. Einrichtung nach einem oder mehreren der vorstehenden Ansprüche, dadurch gekennzeichnet, daß das zweite Umlaufsystem (B) parallel zum ersten Umlaufsystem (A) angeordnet ist.

5. Einrichtung nach einem oder mehreren der vorstehenden Ansprüche, dadurch gekennzeichnet, daß das zweite Umlaufsystem (B) neben der Rücklaufstrecke (RL) des ersten Umlaufsystems (A) vorgesehen ist.

6. Einrichtung nach einem oder mehreren der vorstehenden Ansprüche, dadurch gekennzeichnet, daß das zweite Umlaufsystem (B) an einer der Vorlaufstrecke (VL) abgewandten Außenseite der Rücklaufstrecke (RL) des ersten Umlaufsystems (A) vorgesehen ist.

7. Einrichtung nach einem oder mehreren der vorstehenden Ansprüche, dadurch gekennzeichnet, daß die Förderrichtung der Rücklaufstrecke (RL) des ersten Umlaufsystems (A) und die Förderrichtung des zweiten Umlaufsystems (B) gleich sind.

8. Einrichtung nach einem oder mehreren der vorstehenden Ansprüche, dadurch gekennzeichnet, daß die Bildverarbeitungsstation (5) hinter einer Beschickungsstation (4) des ersten Umlaufsystems (A) und vor der Nachbearbeitungsstation (6) angeordnet ist.

9. Einrichtung nach einem oder mehreren der vorstehenden Ansprüche, dadurch gekennzeichnet, daß die Beschickungsstation (4) für die Aufnahme eines oder mehrerer verschiedener Werkstücke vorgesehen ist, denen ein oder mehrere mit unterschiedlichen Aufnahmen ausgestattete Werkstückträger zugeordnet sind.

10. Einrichtung nach einem oder mehreren der vorstehenden Ansprüche, dadurch gekennzeichnet, daß die Bildverarbeitungsstation (5) für die Prüfung mehrerer verschiedener Werkstücke und/oder Werkstückträger in beliebiger Reihenfolge ausgebildet ist.

11. Einrichtung nach einem oder mehreren der vorstehenden Ansprüche, dadurch gekennzeichnet, daß der Nachbearbeitungsstation (6) ein Fehlermeldesystem der Bildverarbeitungsstation (5) und eine die Stationssteuerung beeinflussende Freigabeguittierung zugeordnet ist.

12. Einrichtung nach einem oder mehreren der vorstehenden Ansprüche, dadurch gekennzeichnet, daß die Pressenstation (7 bis 12) einen Nebenschlußförderer (13) für den Werkstückträger und ein vertikal und horizontal verfahrbares Handlingsystem (14) mit einem Greifer für das Werkstück aufweist.

13. Einrichtung nach einem oder mehreren der vorstehenden Ansprüche, dadurch gekennzeichnet, daß das Werkstück ein Metallgitter ist und daß die Bearbeitungsstation (7 bis 12) ein Schnittwerkzeug zur Abtrennung von elektrischen Leiterstegen aus dem Metallgitter aufweist.

14. Einrichtung nach einem oder mehreren der vorstehenden Ansprüche, dadurch gekennzeichnet, daß hinter der Umsetzstation (16) des ersten Umlaufsystems (A) eine die Werkstückeinzelteile verbindende Schweißstation (17) vorgesehen ist.

15. Einrichtung nach einem oder mehreren der vorstehenden Ansprüche, dadurch gekennzeichnet, daß dem zweiten Umlaufsystem (B) mindestens eine die Position der auf die Ergänzungswerkstücke aufgesetzten Werkstückeinzelteile überprüfende Bildverarbeitungsstation (22, 39 bis 43) zugeordnet ist.

16. Einrichtung nach einem oder mehreren der vorstehenden Ansprüche, dadurch gekennzeichnet, daß das erste Umlaufsystem (A) eine Endbearbeitungsstation (44) für die Werkstücke aufweist.

17. Einrichtung nach einem oder mehreren der vorstehenden Ansprüche, dadurch gekennzeichnet, daß am Ende des zweiten Umlaufsystems (B) eine die Werkstückträger oder Werkstücke absenkende Liftstation vorgesehen ist.

18. Einrichtung nach einem oder mehreren der vorstehenden Ansprüche, dadurch gekennzeichnet, daß den Werkstückträgern des ersten Umlaufsystems (A) ein elektronisches Identifikations- und Kodiersystem zugeordnet ist und daß Schreib- und Leseköpfe dieses Systems über Schnittstellen an ein statistisches Prozesskontrollsystem (SPS) angeschlossen sind.

## Claims

1. Device comprising a transporting system for the processing of workpieces that can be positioned on workpiece carriers, a first circulating system (A) and a second circulating system (B) being provided for the workpiece carriers and at least one of the circulating systems (A, B) possessing a forward section (VL) and a return section (RL), characterized in that, after a finishing station (6) of the first circulating system (A), one or more presses (7, 12) are provided, to which each of the differently shaped workpieces can be fed, and behind the pressing station (7 to 12) at least one conversion station (15, 16), assembling together and/or amplifying the workpiece individual parts, is provided, that at least one feed device (19, 23 to 27), offering up amplifying workpieces, and at least one manipulator (18, 28 to 32), laying the amplifying workpieces on associated workpiece carriers of the second circulating system (B) belong to the second circulating system (B), that the second circulating system (B) transports the amplifying workpieces on their workpiece carriers alongside the workpiece individual components of the workpiece carriers of the first circulating system (A), that after the manipulator (18, 28 to 32) of the second circulating system (B) at least one assembling robot (21, 33 to 38), placing the workpiece individual components from the workpiece carriers of the first circulating system (A) on the amplifying workpieces of the second circulating system (B) is disposed, that at least one image processing station (5, 22, 39 to 43) testing the workpieces is provided, which possesses at least one camera which records the actual values of the workpieces, which values are fed to a computer, which compares the actual values with the stored theoretical values of the workpieces and signals inadmissible value deviations, and that the image processing station (5, 22, 39 to 43) and further processing stations (4 and 6 to 45) of the first circulating system (A) and of the second circulating system (B) are linked to one another by a computer (47), which controls the individual stations and coordinates the data exchange between the stations.

2. Device according to the preceding claim, characterized in that the forward section (VL) of the first circulating system (A) is connected to the return section (RL) by at least one change-direction component (2, 3), changing the direction of conveying.

3. Device according to one or more of the preceding claims, characterized in that the forward section (VL) and the return section (RL) are spaced apart parallel to each other.

4. Device according to one or more of the preceding claims, characterized in that the second circulating system (B) is disposed parallel to the first circulating system (A).

5. Device according to one or more of the preceding claims, characterized in that the second circulating system (B) is provided alongside the return section (RL) of the first circulating system (A).

6. Device according to one or more of the preceding claims, characterized in that the second circulating system (B) is provided at an outer side of the return section (RL) of the first circulating system (A), remote from the forward section (VL).

7. Device according to one or more of the preceding claims, characterized in that the conveying direction of the return section (RL) of the first circulating system (A) and the conveying direction of the second circulating system (B) are the same.

8. Device according to one or more of the preceding claims, characterized in that the image processing station (5) is disposed behind a feed station (4) of the first circulating system (A) and before the finishing station (6).

9. Device according to one or more of the preceding claims, characterized in that the feed station (4) is provided for receiving one or more different workpieces, with which one or more workpiece carriers equipped with different seatings are associated.

10. Device according to one or more of the preceding claims, characterized in that the image processing station (5) is constructed for the testing of several different workpieces and/or workpiece carriers in any sequence.

11. Device according to one or more of the preceding claims, characterized in that a fault announcing system of the image processing station (5) and a release acknowledgement that influences the station control are associated with the finishing station (6).

12. Device according to one or more of the preceding claims, characterized in that the press station (7 to 12) possesses a shunt conveyor (13) for the workpiece carrier and a vertically and horizontally traversable handling system (14) comprising a grab for the workpiece.

13. Device according to one or more of the preceding claims, characterized in that the workpiece is a metal grid and that the processing station (7 to 12) possesses a cutting tool for cutting out electrical conductor webs from the metal grid.

14. Device according to one or more of the preceding claims, characterized in that, behind the conversion station (16) of the first circulating system (A), a welding station (17), connecting together the workpiece individual components, is provided.

15. Device according to one or more of the preceding claims, characterized in that at least one image processing station (22, 39 to 43), testing the position of the workpiece individual components placed on the amplifying workpieces, is associated with the second circulating system (B).

16. Device according to one or more of the preceding claims, characterized in that the first circulating system (A) possesses a final processing station (44) for the workpieces.

17. Device according to one or more of the preceding claims, characterized in that, at the end of the second circulating system (B), a lift station for lowering the workpiece carriers or workpieces is provided.

18. Device according to one or more of the preceding claims, characterized in that an electronic identification and coding system is associated with the workpiece carriers of the first circulating system (A), and that writing and reading heads of this system are connected via interfaces to a statistical process control system (SPS).

## Revendications

1. Installation comprenant un système de transport et destiné à usiner des pièces positionnables par l'intermédiaire de porte-pièces bénéficiant d'un premier et d'un second système de circulation (A, B) dont un au moins comprend une ligne d'avancement (VL) et une ligne de retour (RL),
caractérisée en ce que
- en aval d'un poste de reprise (6) du premier système de circulation (A), il est prévu une ou plusieurs presses (7, 12) à chacune desquelles peut être amenée une des pièces de constitutions différentes ;
- en aval des postes de travail à la presse (7 à 12), il est prévu au moins un poste (15, 16) de conversion assemblant et/ou complétant les pièces individuelles ;
- le second système de circulation (B) comprend au moins un dispositif d'alimentation (19, 23 à 27) amenant des pièces complémentaires, ainsi qu'un manipulateur (18, 28 à 32) déposant ces pièces sur des porte-pièces correspondants du système (B) ;
- les porte-pièces avec leurs pièces complémentaires sont transportés par le second système de circulation (B), à côté des pièces individuelles des porte-pièces du premier système de circulation (A) ;
- le manipulateur (18, 28 à 32) du second système de circulation (B) est suivi par au moins un robot de montage (21, 33 à 38) déposant les pièces individuelles provenant des porte-pièces du premier système de circulation (A) sur les pièces complémentaires du second système de circulation (B) ;
- il est prévu au moins un poste de traitement d'images (5, 22, 39 à 43) servant au contrôle des pièces et comportant une caméra enregistrant les caractéristiques réelles des pièces et les adressant à un calculateur qui compare ces valeurs réelles aux valeurs de consigne mises en mémoire et qui signale les écarts inadmissibles de ces valeurs ;
- le poste de traitement d'images (5,22, 39 à 43) et d'autres postes d'usinage (4 et 6 à 45) du premier système de circulation (A) et du second système de circulation (B) sont reliés entre eux par un ordinateur (47) qui commande les différents postes et coordonne l'échange de données entre les postes.

2. Installation selon la revendication précédente,
caractérisée en ce que
la ligne d'avancement (VL) du premier système de circulation (A) est reliée à la ligne de retour (RL) par au moins une partie de renvoi (2, 3) modifiant la direction de déplacement.

3. Installation selon une ou plusieurs des revendications précédentes,
caractérisée en ce que
la ligne d'avancement (VL) et la ligne de retour (RL) sont disposées parallèlement et à une certaine distance l'une de l'autre.

4. Installation selon une ou plusieurs des revendications précédentes,
caractérisée en ce que
le second système de circulation (B) est parallèle au premier (A).

5. Installation selon une ou plusieurs des revendications précédentes,
caractérisée en ce que
le second système de circulation (B) est placé à côté de la ligne de retour (RL) du premier système de circulation (A).

6. Installation selon une ou plusieurs des revendications précédentes,
caractérisée en ce que
le second système de circulation (B) est placé le long du côté externe, éloigné de la ligne d'avancement (VL), de la ligne de retour (RL) du premier système de circulation (A).

7. Installation selon une ou plusieurs des revendications précédentes,
caractérisée en ce que
la direction de circulation de la ligne de retour (RL) du premier système de circulation (A) et la direction de circulation du second système (B) sont les mêmes.

8. Installation selon une ou plusieurs des revendications précédentes,
caractérisée en ce que
le poste de traitement d'images (5) est situé en aval d'un poste d'alimentation (4) du premier système de circulation (A) et en amont du poste de reprise (6).

9. Installation selon une ou plusieurs des revendications précedentes,
caractérisée en ce que
le poste d'alimentation (4) est prévu pour recevoir une ou plusieurs pièces différentes auxquelles sont associées un ou plusieurs porte-pièces équipés de récepteurs différents.

10. Installation selon une ou plusieurs des revendications précédentes,
caractérisée en ce que
le poste de traitement d'images (5) servant à contrôler plusieurs pièces et/ou porte-pièces différents présente une disposition en série.

11. Installation selon une ou plusieurs des revendications précédentes,
caractérisée en ce que
le poste de reprise (6) est associé à un système de signalisation de défauts faisant partie du poste de traitement d'images (5) ainsi qu'une validation homologuée agissant sur la commande du poste de reprise.

12. Installation selon une ou plusieurs des revendications précédentes,
caractérisée en ce que
chaque poste de formage à la presse (7 à 12) est équipé d'un transporteur en dérivation (13) destiné aux porte-pièces ainsi que d'un système de manutention (14) mobile verticalement et horizontalement et équipé d'un organe de prise de la pièce.

13. Installation selon une ou plusieurs des revendications précédentes,
caractérisée en ce que
la pièce est une grille métallique et que chaque poste d'usinage (7 à 12) est équipé d'un outil de coupe servant à retirer des segments de conducteurs électriques appartenant à la grille.

14. Installation selon une ou plusieurs des revendications précédentes,
caractérisée en ce que
il est prévu en aval de la station de renvoi (16) du premier système de circulation (A) un poste de soudure (17) servant à relier les parties de la pièce.

15. Installation selon une ou plusieurs des revendications précédentes,
caractérisée en ce que
au second système de circulation (B) est associé au moins un poste de traitement d'images (22, 39 à 43) contrôlant la position des pièces individuelles placées sur les pièces complémentaires.

16. Installation selon une ou plusieurs des revendications précédentes,
caractérisée en ce que
le premier système de circulation (A) comprend un poste d'usinage final (44) des pièces.

17. Installation selon une ou plusieurs des revendications précédentes,
caractérisée en ce que
il est prévu, à l'extrémité du second système de circulation (B) un poste équipé d'un ascenseur faisant descendre les porte-pièces ou les pièces.

18. Installation selon une ou plusieurs des revendications précédentes,
caractérisée en ce que
aux porte-pièces du premier système de circulation (A) est associé un système d'identification et de codage, dont les têtes d'impression et de lecture sont raccordées par des interfaces à un système statistique de contrôle de processus (SPS).
